# EUROPEAN PATENT SPECIFICATION

(11) **EP 0 943 193 B1**
(45) Date of publication and mention of the grant of the patent: **06.10.2004**
(21) Application number: 97945805.6
(22) Date of filing: 02.12.1997
(51) Int. Cl.: H04J 3/06, H03L 7/06

(54) **A METHOD AND A CIRCUIT FOR GENERATING A CENTRAL CLOCK SIGNAL**
VERFAHREN UND SCHALTUNG ZUR ERZEUGUNG EINES ZENTRALEN TAKTSIGNALS
PROCEDE ET CIRCUIT POUR PRODUIRE UN SIGNAL D'HORLOGE CENTRAL

(30) Priority: 04.12.1996 DK 138096
(43) Date of publication of application: 22.09.1999
(73) Proprietor: TELLABS DENMARK A/S, 2750 Ballerup (DK)
(72) Inventor: HEDE, Carsten, DK-2610 Rodovre (DK)
(74) Representative: Boesen, Johnny Peder
(86) International application number: PCT/DK1997/000549
(87) International publication number: WO 1998/025368

(56) References cited:
- EP-A- 0 718 995
- GB-A- 2 257 603

## Description

The invention relates to a method of generating a central clock signal which may periodically be locked to a selected one of a plurality of external clock signals. Each of the external clock signals is generated in phase-locked relationship with an external reference signal by a digital phase-locked loop comprising a numerically controlled oscillator, which generates the clock signal of the loop by division of a common system clock signal, fed to all loops, by a factor which is determined by a digital error signal indicating a phase difference between the clock signal of the loop and the external reference signal of the loop.

The invention also relates to a corresponding circuit.

Synchronous telecommunications systems, such as e.g. an SDH network (Synchronous Digital Hierarchy), consist of a large number of network elements which each comprise a system clock generator which generates an internal clock signal to control the network element. An SDH network element may e.g. have an internal system clock generator of 77.76 MHz. This will typically be phase-locked to an 8 kHz signal derived from the received data, said 8 kHz corresponding to the frame frequency of the transmitted communications signals. For example, it is possible to lock to data received from another network element, or to one of the lower order signals, e.g. a PDH signal, which the network element receives with a view to introducing these into the SDH structure. Thus, each network element has its own system clock generator, typically a phase-locked loop (PLL).

The individual network elements, which may e.g. be multiplexers or Add/Drop multiplexers, will frequently serve to multiplex a large number of plesiochronous channels, e.g. 2 Mbits/s channels, into the SDH system. In principle, each of these 2 Mbits/s channels will have its own clock which is independent of the other channels and of the SDH system. Although the clock frequency of each channel will be close to the others, since all 1 of them are produced as multiples of 8 kHz, but not necessarily the same 8 kHz source, their mutual phase may vary freely.

GB 2 257 603 shows an example of an SDH system in which an SDH network element including a desynchronizer can be synchronized to a 2 Mbit timing clock.

In such a network element it is desirable to have a central clock signal which is phase-locked to an arbitrary one of the plesiochronous channels to which it is connected. The invention relates to such locking, but may also be used in other applications in which there is a need for a central clock signal which is phase-locked to an arbitrary one of a plurality of clock signals.

Typically, each input gate or module, which receives a plesiochronous channel, will be provided with a phase-locked loop which generates a clock signal corresponding thereto on the basis of the received data. It is known to transfer each of these clock signals to a central clock unit which can then select an arbitrary one of these clock signals as the central clock signal. However, it takes a large bandwidth to transfer the many clock signals from the individual modules to the central clock unit, and it moreover means that a phase jump will typically occur in the central clock signal when the central clock unit switches from one clock signal to another.

Such a phase jump may cause the network to get out of synchronization, and is therefore undesirable.

Accordingly, an object of the invention is to provide a method of the type stated in the opening paragraph, which requires a smaller bandwidth between the individual modules and the central clock unit, and which enables switching from one module to another without a phase jump in the central clock signal.

This is achieved according to the invention in that the digital error signal from the selected phase-locked loop is transferred to a central numerically controlled oscillator, which generates the central clock signal by dividing the common system clock signal by a factor determined by the transferred digital signal.

When just the digital error signal is transferred, a considerable saving in bandwidth is achieved, as this varies with a much smaller frequency than the clock signal itself. Further, the central numerically controlled oscillator will serve as a slave of the corresponding oscillator in the selected loop, and when switching to another loop it will merely instead receive the error signal from the new loop, so that a phase jump will not occur in its output signal which constitutes the central clock signal.

A further saving in bandwidth may be achieved when, as stated in claim 2, the digital error signal from the selected loop is integrated over a period of time before it is transferred to the central numerically controlled oscillator.

As mentioned, the invention moreover relates to a circuit for generating a central clock signal of the stated type. When the circuit comprises a central numerically controlled oscillator and is adapted to transfer the digital error signal from the selected phase-locked loop to the central numerically controlled oscillator, while the numerically controlled oscillator is adapted to generate the central clock signal by division of the common system clock signal by a factor which is determined by the transferred digital error signal, then, as mentioned above, a saving in bandwidth is achieved and no phase jump occurs when switching to another loop.

As stated in claim 4, a further saving in bandwidth may be achieved in that each of the phase-locked loops moreover comprises means for integrating the digital error signal of the loop over a period of time before it is transferred to the central numerically controlled oscillator. As stated in claim 5, these means may expediently comprise a counter capable of counting the number of times the numerically controlled oscillator has divided the system clock signal by a specific factor within a given period of time. Then, it suffices to transfer the count once for each period.

The circuit will be particularly useful for an SDH system when, as stated in claim 6, the common system clock signal has a frequency of approximately 77.76 MHz. When, as stated in claim 7, the clock signal of each of the phase-locked loops has a frequency of approximately 2.048 MHz, the system is particularly useful for 2.048 Mbits/s channels, which are mainly used in Europe, while, when the clock signal of the phase-locked loops has a frequency of approximately 1.544 MHz, as stated in claim 8, it is particularly useful for 1.544 Mbits/s channels, which are mainly used in North America.

The invention will now be described more fully below with reference to the drawing, in which
fig. 1 shows an embodiment of the invention in which a digital error signal is transferred from a module to a central numerically controlled oscillator, and
fig. 2 shows a variant of an external module.

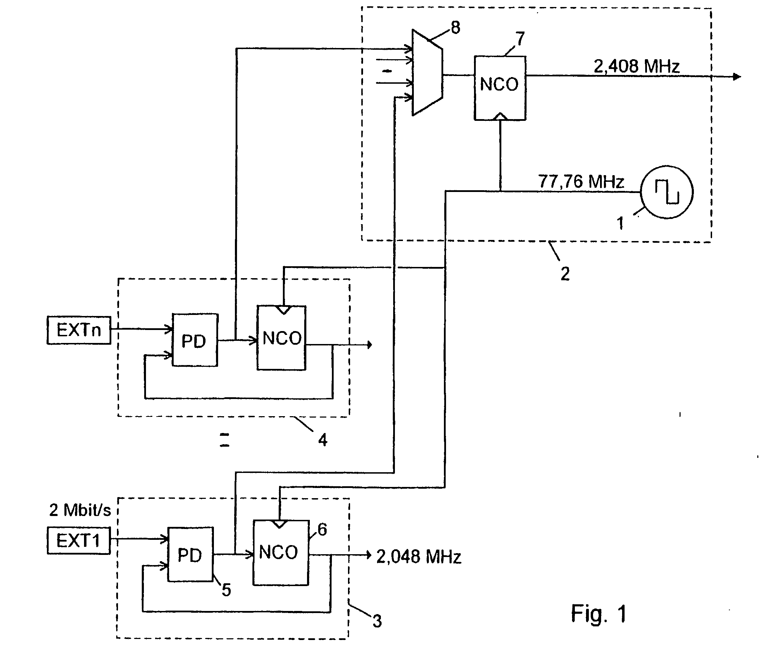

Fig. 1 shows an example of an embodiment of the invention. In the shown example, the invention is applied in a network element in an SDH network in which a plurality of 2 Mbits/s channels are to be introduced into the SDH system. A system clock generator 1, which generates a clock signal of 77.76 MHz, is placed on a central module 2, while for each 2 Mbits/s channels there is an external module, of which the two modules 3 and 4 are shown here.

Each of the external modules contains a clock regeneration circuit, which consists of a digital phase-locked loop having a phase detector 5 and a numerically controlled oscillator (NCO) 6. This circuit regenerates a clock signal of 2.048 MHz from an arriving data signal (e.g. EXT1) of 2 Mbits/s. The numerically controlled oscillator is designed as a programmable divider which divides the system clock signal of the 77.76 MHz. Theoretically, the division ratio should be 77.76/2.048 = 37.97, and the divider 6 is therefore adapted to be capable of dividing by a factor of 37, 38 or 39 depending on a control signal which may assume the values (-1,0,1). The phase detector 5 is therefore adapted to emit one of these values depending on the phase difference between the arriving signal and the regenerated clock signal, and the control signal is therefore also called an error signal.

According to the prior art, generation of a central clock signal of 2.048 MHz phase-locked to an arbitrary one of the many channels would require feeding each of the regenerated 2.048 MHz clock signals to the central module 2, where one of them would be selected as the instantaneous central clock signal. However, it requires a considerable bandwidth to transfer the many 2 MHz signals, and moreover a phase jump would occur in the central clock signal when switching from one channel to another.

Instead, in the shown embodiment of the invention, a numerically controlled oscillator or divider 7, which may be quite similar to the oscillators 6 placed on the external modules, is arranged on the central module 2, and then just the error signal from each external module is transferred to the central divider 7. The central divider 7 will thus follow the divider 6 on the selected module closely, as they receive exactly the same error signal. This means that the two dividers or oscillators have exactly the same frequency, but not necessarily the same phase. A selector 8 connects the selected error signal to the divider 7.

When switching from one module to another, the divider 7 merely receives a new error signal, but will otherwise not be affected, and thus no phase jump will occur in the central clock signal.

The above description relates to a situation in which a plurality of 2 Mbits/s channels are introduced into an SDH system. The same circuit may also be used when e.g. 1.5 Mbits/s channels are involved. In that case, the regenerated clock signal is of 1.544 MHz, and the division ratio of the programmable divider should therefore be 77.76/1.544 = 50.36 in theory. In this case, the divider is therefore arranged to be capable of dividing by a factor of 50 or 51 depending on the error signal, which may here assume the values {0, 1}.

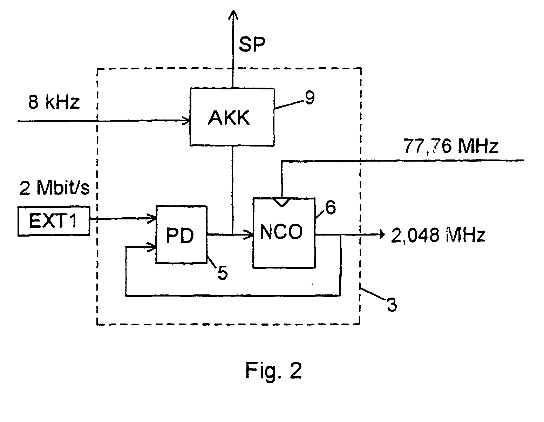

Fig. 2 shows a variant of the external module 3. Instead of currently transferring the error signal to the central module 2 like in fig. 1, the values are here accumulated in an accumulator 9. The accumulator may e.g. be an 8-bit counter which counts the number of times the programmable counter 6 has counted to 37 or 39 (for 2 Mbits/s) or 50 (for 1.5 Mbits/s) within a specific period of time. In the example, the count, also called synchronization pointer (SP), is transferred to the central module 2 once for each SDH frame, and the counter 9 is therefore controlled by an 8 kHz signal, which transfers SP and then resets the counter. Additional bandwidth is saved hereby, since it is just necessary to transfer a byte (SP) for each frame period.

In the 2 Mbits/s case, the count (SP) of the counter 9 is increased by 1 (i.e. SP = SP + 1) when the divider 6 divides by 37. It is maintained unchanged (i.e. SP = SP + 0) when the divider 6 divides by 38, and it is reduced by one 1 (i.e. SP = SP - 1) when the divider 6 divides by 39. As the theoretical division ratio 37.97 is close to 38, the divider 6 will divide by 38 in the vast majority of cases, and the count will therefore assume a value as low as 8 for a period at nominal frequencies, and, when the frequencies vary, it will be within the range 0-16. In this case, a 4-bit counter will thus be sufficient.

In case of a 1.5 Mbits/s channel, the count (SP) of the counter 9 is increased by 1 (i.e. SP = SP + 1) when the divider 6 divides by 50, and it is maintained unchanged (i.e. SP = SP + 0) when the divider 6 divides by 51. Here the count will assume the value 123 for a period at nominal frequencies, and a counter of 7 or 8 bits has to be used.

On the central module 2, the SP value is fed from the selected module to the divider 7 which, in the subsequent period, adjusts its division ratio to the SP value just received.

Although a preferred embodiment of the present invention has been described and shown, the invention is not restricted to it, but may also be embodied in other ways within the scope of the subject-matter defined in the appended claims.

## Claims

1. A method of generating a central clock signal which may periodically be locked to a selected one of a plurality of external clock signals, each of said external clock signals being generated in phase-locked relationship with an external reference signal by a digital phase-locked loop comprising a numerically controlled oscillator (6), which generates the clock signal of the loop by division of a common system clock signal, fed to all loops, by a factor which is determined by a digital error signal indicating a phase difference between the clock signal of the loop and the external reference signal of the loop, **characterized in that** the digital error signal from the selected phase-locked loop is transferred to a central numerically controlled oscillator (7), which generates the central clock signal by division of the common system clock signal by a factor determined by the transferred digital error signal.

2. A method according to claim 1, **characterized in that** the digital error signal from the selected loop is integrated over a period of time before it is transferred to the central numerically controlled oscillator (7) .

3. A circuit for generating a central clock signal which may periodically be locked to a selected one of a plurality of external clock signals, each of said external clock signals being generated in phase-locked relationship with an external reference signal by a digital phase-locked loop comprising a numerically controlled oscillator(6), which generates the clock signal of the loop by division of a common system deck signal, fed to all loops, by a factor which is determined by a digital error signal indicating a phase difference between the clock signal of the loop and the external reference signal of the loop, **characterized in that** the circuit comprises a central numerically controlled oscillator (7) and is adapted to transfer the digital error signal from the selected phase-locked loop to the central numerically controlled oscillator (7), and that the numerically controlled oscillator (7) is adapted to generate the central clock signal by division of the common system clock signal by a factor which is determined by the transferred digital error signal.

4. A circuit according to claim 3, **characterized in that** each of the phase-locked loops moreover comprises means (9) for integrating the digital error signal of the loop over a period of time before it is transferred to the central numerically controlled oscillator (7).

5. A circuit according to claim 4, **characterized in that** said integrating means (9) comprise a counter capable of counting the number of times the numerically controlled osc: llator (6) has divided the system clock signal by a specific factor within a given period of time.

6. A circuit according to claims 3-5, **characterized in that** the common system clock signal has a frequency of approximately 77.76 MHz.

7. A circuit according to claims 3-6, **characterized in that** the clock signal of each of the phase-locked loops has a frequency of approximately 2.048 MHz.

8. A circuit according to claims 3-6, **characterized in that** the clock signal of each of the phase-locked loops has a frequency of approximately 1.544 MHz.

## Patentansprüche

1. Verfahren zur Erzeugung eines zentralen Taktsignals, das mit einem ausgewählten einer Mehrzahl von externen Taktsignalen periodisch gerastet werden kann, wobei jedes der externen Taktsignale in phasengerasteter Beziehung mit einem externen Bezugssignal durch eine digitale Phasenregelschleife erzeugt wird, die einen numerisch gesteuerten Oszillator (6) umfasst, der das Taktsignal der Schleife durch Teilung eines allen Schleifen zugeführten gemeinsamen Systemtaktsignals durch einen Faktor erzeugt, der durch ein digitales Fehlersignal bestimmt ist, das einen Phasenunterschied zwischen dem Taktsignal der Schleife und dem externen Bezugssignal der Schleife anzeigt, **dadurch gekennzeichnet, dass** das digitale Fehlersignal von der ausgewählten Phasenregelschleife zu einem zentralen numerisch gesteuerten Oszillator (7) übertragen wird, der das zentrale Taktsignal durch Teilung des gemeinsamen Systemtaktsignals durch einen Faktor erzeugt, der durch das übertragene digitale Fehlersignal bestimmt wird.

2. Verfahren nach Anspruch 1, **dadurch gekennzeichnet, dass** das digitale Fehlersignal von der ausgewählten Schleife über einen Zeitraum integriert wird, bevor es zum zentralen numerisch gesteuerten Oszillator (7) übertragen wird.

3. Schaltung zur Erzeugung eines zentralen Taktsignals, das mit einem ausgewählten einer Mehrzahl von externen Taktsignalen periodisch gerastet werden kann, wobei jedes der externen Taktsignale in phasengerasteter Beziehung mit einem externen Bezugssignal durch eine digitale Phasenregelschleife erzeugt wird, die einen numerisch gesteuerten Oszillator (6) umfasst, der das Taktsignal der Schleife durch Teilung eines allen Schleifen zugeführten gemeinsamen Systemtaktsignals durch einen Faktor erzeugt, der durch ein digitales Fehlersignal bestimmt ist, das einen Phasenunterschied zwischen dem Taktsignal der Schleife und dem externen Bezugssignal der Schleife anzeigt, **dadurch gekennzeichnet, dass** die Schaltung einen zentralen numerisch gesteuerten Oszillator (7) umfasst und angepasst ist, um das digitale Fehlersignal von der ausgewählten Phasenregelschleife zum zentralen numerisch gesteuerten Oszillator (7) zu übertragen, und dass der numerisch gesteuerte Oszillator (7) angepasst ist, um das zentrale Taktsignal durch Teilung des gemeinsamen Systemtaktsignals durch einen Faktor zu erzeugen, der durch das übertragene digitale Fehlersignal bestimmt ist.

4. Schaltung nach Anspruch 3, **dadurch gekennzeichnet, dass** jede der Phasenregelschleifen außerdem eine Einrichtung (9) zur Integration des digitalen Fehlersignals der Schleife über einen Zeitraum umfasst, bevor es zum zentralen numerisch gesteuerten Oszillator (7) übertragen wird.

5. Schaltung nach Anspruch 4, **dadurch gekennzeichnet, dass** die Integrationseinrichtungen (9) einen Zähler umfassen, der die Anzahl von Malen zählen kann, die der numerisch gesteuerte Oszillator (6) das Systemtaktsignal in einem vorgegebenen Zeitraum durch einen speziellen Faktor geteilt hat.

6. Schaltung nach den Ansprüchen 3-5, **dadurch gekennzeichnet, dass** das gemeinsame Systemtaktsignal eine Frequenz von ungefähr 77,76 MHz aufweist.

7. Schaltung nach den Ansprüchen 3-6, **dadurch gekennzeichnet, dass** das Taktsignal von jeder der Phasenregelschleifen eine Frequenz von ungefähr 2,048 MHz aufweist.

8. Schaltung nach den Ansprüchen 3-6, **dadurch gekennzeichnet, dass** das Taktsignal von jeder der Phasenregelschleifen eine Frequenz von ungefähr 1,544 MHz aufweist.

## Revendications

1. Méthode destinée à générer un signal d'horloge central qui peut de manière périodique être verrouillé à un signal sélectionné parmi une pluralité de signaux d'horloge extérieurs, chacun desdits signaux d'horloge extérieurs étant générés en relation de verrouillage de phase avec un signal de référence extérieur par une boucle à verrouillage de phase numérique comprenant un oscillateur commandé numériquement (6), qui génère le signal d'horloge de la boucle par division d'un signal d'horloge système commun, appliqué à toutes les boucles, par un facteur qui est déterminé par un signal d'erreur numérique indiquant une différence de phase entre le signal d'horloge de la boucle et le signal de référence extérieur de la boucle, **caractérisé en ce que** le signal d'erreur numérique provenant de la boucle à verrouillage de phase est transféré à un oscillateur central commandé numériquement (7) qui génère un signal d'horloge central par division du signal d'horloge système commun par un facteur déterminé par le signal d'erreur numérique transféré.

2. Méthode selon la revendication 1, **caractérisée en ce que** le signal d'erreur numérique provenant de la boucle sélectionnée est intégré sur une période de temps avant d'être transféré vers l'oscillateur central commandé numériquement (7).

3. Circuit destiné à générer un signal d'horloge central qui peut de manière périodique être verrouillé à un signal sélectionné parmi une pluralité de signaux d'horloge extérieurs, chacun desdits signaux d'horloge extérieurs étant générés en relation de verrouillage de phase avec un signal de référence extérieur par une boucle à verrouillage de phase numérique comprenant un oscillateur commandé numériquement (6), qui génère le signal d'horloge de la boucle par division d'un signal d'horloge système commun, appliqué à toutes les boucles, par un facteur qui est déterminé par un signal d'erreur numérique indiquant une différence de phase entre le signal d'horloge de la boucle et le signal de référence extérieur de la boucle, **caractérisé en ce que** le circuit comprend un oscillateur central commandé numériquement (7) et est conçu pour transférer le signal d'erreur numérique de la boucle à verrouillage de phase sélectionnée à l'oscillateur central commandé numériquement (7) et **en ce que** l'oscillateur central commandé numériquement (7) est conçu pour générer le signal d'horloge central par division du signal d'horloge système commun par un facteur déterminé par le signal d'erreur numérique transféré.

4. Circuit selon la revendication 3, **caractérisé en ce que** chacune des boucles de phase bloquée comprend en outre des moyens (9) pour intégrer le signal d'erreur numérique de la boucle sur une durée avant qu'il ne soit transféré à l'oscillateur central commandé numériquement (7).

5. Circuit selon la revendication 4, **caractérisé en ce que** lesdits moyens d'intégration (9) comprennent un compteur capable de compter le nombre de fois que l'oscillateur commandé numériquement (6) a divisé le signal d'horloge système par un facteur spécifique pendant une durée donnée.

6. Circuit selon les revendications 3 à 5, **caractérisé en ce que** le signal d'horloge système commun présente une fréquence d'approximativement 77,76 MHz.

7. Circuit selon les revendications 3 à 6, **caractérisé en ce que** le signal d'horloge de chacune des boucles de phase bloquée présente une fréquence d'approximativement 2,048 MHz.

8. Circuit selon les revendications 3 à 6, **caractérisé en ce que** le signal d'horloge de chacune des boucles à verrouillage de phase présente une fréquence d'approximativement 1,544 MHz.
